# EUROPEAN PATENT APPLICATION

(11) **EP 2 684 978 A1**
(43) Date of publication of application: **15.01.2014**
(21) Application number: 12827167.3
(22) Date of filing: 06.07.2012
(51) Int. Cl.: C23C 14/34, B22D 11/00, B22D 11/04, C22C 9/00, C22F 1/08, C22F 1/00

(54) **Cu-Ga ALLOY SPUTTERING TARGET AND METHOD FOR PRODUCING SAME**

(30) Priority: 29.08.2011 JP 2011185591; 22.11.2011 JP 2011255066
(71) Applicant: JX Nippon Mining & Metals Corporation, Tokyo 100-8164 (JP)
(72) Inventor: TAMURA Tomoya, Kitaibaraki-shi Ibaraki 319-1535 (JP); SAKAMOTO Masaru, Kitaibaraki-shi Ibaraki 319-1535 (JP)
(74) Representative: Hoarton, Lloyd Douglas Charles
(86) International application number: PCT/JP2012/067280
(87) International publication number: WO 2013/031381

(57) **Abstract**

The purpose of the invention is to provide a sputtering target formed from a Cu-Ga alloy having a Ga composition of 29 at% or more.
[Problem] Since a Cu-Ga alloy becomes a brittle γ phase-single phase structure when the Ga composition becomes 29 at% or more, it cannot be subject to processes such as rolling and forging. Accordingly, the crystal grain size of the cast structure must be small and uniform so that the cast structure can be used as is. [Solution] It is possible to produce a melted and cast Cu-Ga alloy sputtering target containing 29 to 42.6 at% of Ga, and remainder being Cu and unavoidable impurities by continuously solidifying the Cu-Ga alloy sputtering target under solidifying conditions of a constant cooling rate or higher, wherein an average crystal grain size of a sputter front face is 3 mm or less, and a cross section structure of the target is a columnar structure that has grown in a direction from the sputter front face toward a center plane which is parallel to a sputter face.

## Description

### [Technical Field]

The present invention relates to a Cu-Ga alloy sputtering target to be used upon forming a Cu-In-Ga-Se (hereinafter indicated as "CIGS") quaternary alloy thin film, which is a light-absorbing layer of a thin film solar cell layer, and to a method of producing such a target.

### BACKGROUND

In recent years, the mass production of CIGS-based solar cells which are highly efficient for use as thin film solar cells is progressing, and as a method of producing the light-absorbing layer, the vapor-deposition technique and the selenization method are known. While the solar cells produced via the vapor-deposition technique are advantageous of having high conversion efficiency, they also have drawbacks; namely, low deposition rate, high cost, and low productivity, and the selenization method is more suitable for industrial mass production.

The process of the selenization method can be summarized as follows. Foremost, a molybdenum electrode layer is formed on a soda lime glass substrate, a Cu-Ga layer and an In layer are sputter-deposited thereon, and a CIGS layer is thereafter formed based on high temperature treatment in selenium hydride gas. The Cu-Ga target is used during the sputter deposition of the Cu-Ga layer during the process of forming the CIGS layer based on the foregoing selenization method.

While the conversion efficiency of the CIGS-based solar cells is affected by various manufacturing conditions and characteristics of the constituent materials, the characteristics of the CIGS film also considerably affect the conversion efficiency of the CIGS-based solar cells.

As methods of producing the Cu-Ga target, there are the melting method and the powder method. Generally, while it is said that the impurity contamination of the Cu-Ga target produced via the melting method is relatively low, the Cu-Ga target produced via the melting method also has numerous drawbacks. For example, since the cooling rate cannot be increased, compositional segregation is considerable, and the composition of the film prepared via the sputtering method will gradually change.

Moreover, ingot piping tends to occur during the final stage of cooling the molten metal, and, since the characteristics of the portion around the ingot piping are inferior and such portion cannot be used in the process of processing the target into a predetermined shape, the production yield is inferior.

In addition, as the Ga concentration increases, the brittleness also increases and causes the target to become cracked more easily, and cracks or fractures tend to occur during the processing into a target or during the sputtering process, and this also results in increased costs caused by deterioration of the production yield.

While the prior art document (Patent Document 1) pertaining to the Cu-Ga target based on the melting method describes that compositional segregation could not be observed, analysis results and the like are not indicated in any way. Moreover, while Patent Document 1 also describes that the target was free from brittleness and cracks, there is no description regarding the processing conditions or sputtering conditions, and the subject matter thereof is unclear.

In addition, the Examples of Patent Document 1 indicate results in which the upper limit of the Ga concentration range is only up to 30 wt%, and there is no other description regarding the characteristics including the brittleness and cracks in a high Ga concentration region.

Meanwhile, a target produced via the powder method generally had problems such as the sintered density being low and the impurity concentration being high. While Patent Document 2 relating to the Cu-Ga target describes a sintered compact target, the description is an explanation of conventional technology related to brittleness to the effect that cracks and fractures tend to occur upon cutting a target, and Patent Document 2 produces two types of powders and mixes and sinters these powders in order to resolve the foregoing problem. Among the two types of powders described above, one is powder with a high Ga content and the other is powder with a low Ga content, and Patent Document 2 achieves a two-phase coexisting structure that is encircled by the grain boundary phase.

This process is complicated since two types of powders need to be produced, and, since the respective powders have difference physical properties such as hardness and different structures, it is difficult to obtain a uniform sintered compact simply by mixing and sintering the powders, and the improvement in the relative density cannot be expected.

A low-density target is obviously subject to abnormal discharge and generation of particles, and, if there is foreign matter such as particles on the sputtered film surface, it will also have an adverse effect on the subsequent CIGS film characteristics, and it is highly likely that it will ultimately lead to the considerable deterioration in the conversion efficiency of the CIGS solar cells.

A major problem in the Cu-Ga sputtering target prepared based on the powder method is that the process is complicated, and the quality of the prepared sintered compact is not necessarily favorable, and there is also a significant disadvantage in that the production cost will increase. From this perspective, the melting and casting method is desirable, but as described above, there are problems in the production process, and the quality of the target itself could not be improved.

As conventional technology, there is, for instance, Patent Document 3. Here, described is technology of processing a target by subjecting high purity copper and copper alloy doped with trace amounts of titanium in an amount of 0.04 to 0.15 wt% or zinc in an amount of 0.014 to 0.15 wt% to continuous casting. This kind of alloy can be easily cast and processed, and cannot be applied to the production of a low-workability Cu-Ga alloy target in which the additive amount of gallium exceeds 29 at%.

Patent Document 4 discloses technology of processing a sputtering target by similarly subjecting high purity copper to continuous casting to obtain a rod shape that is free from cast defects, and rolling the obtained rod shape and processing it into a sputtering target. This kind of alloy can also be easily cast and processed, and cannot be applied to the production of a low-workability Cu-Ga alloy target in which the additive amount of gallium exceeds 29 at%.

Patent Document 5 describes producing a single-crystallized sputtering target by adding, to aluminum, a material selected from 24 elements such as Ag and Au, in an amount of 0.1 to 3.0 wt%, and performing continuous casting thereto. Nevertheless, this kind of alloy can also be easily cast and processed, and cannot be applied to the production of a low-workability Cu-Ga alloy target in which the additive amount of gallium exceeds 29 at%.

While foregoing Patent Documents 3 to 5 illustrate examples of producing a target based on the continuous casting method, all examples are limited to materials that can be easily cast and processed, and it cannot be said that Patent Documents 3 to 5 offer any disclosure capable of resolving the problems existing in the production of a low-workability Cu-Ga alloy target.
Patent Document 1: JP-A-2000-73163
Patent Document 2: JP-A-2008-138232
Patent Document 3: JP-A-H5-311424
Patent Document 4: JP-A-2005-330591
Patent Document 5: JP-A-H7-300667

### SUMMARY OF THE INVENTION

### [Problems to be Solved by the Invention]

A Cu-Ga alloy becomes a brittle γ phase-single phase structure when the Ga composition becomes 29 at% or more. Thus, even if a target is prepared via casting, it is not possible to subsequently perform processes such as rolling and forging, and the cast structure will remain as is. Accordingly, a sputtering target of a cast structure becomes a requirement. In order to obtain a target, which is of good quality in comparison to a sintered compact target, based on a sputtering target having a cast structure, it is important that the crystal grains are small and unified. This kind of target yields favorable sputtering characteristics, and can form a sputtered film of higher quality. Nevertheless, with the ordinary casting method, since the solidification rate will change depending on the location when the target is enlarged to a certain size, it becomes extremely difficult to cause the entire face to be uniform. The present invention provides a target having a cast structure in which the crystal grain size is small and uniform by continuously solidifying the Cu-Ga alloy sputtering target under solidifying conditions of a constant cooling rate or higher.

### [Means for Solving the Problems]

In order to achieve the foregoing object, as a result of intense study, the present inventors and others discovered that it is possible to obtain a Cu-Ga alloy sputtering target with an adjusted crystal grain size based on the continuous casting method, and thereby completed this invention.

Based on the foregoing discovery, the present invention provides the following invention.
1) A melted and cast plate-like Cu-Ga alloy sputtering target containing 29 to 42.6 at% of Ga and remainder being Cu and unavoidable impurities, wherein an average crystal grain size of a center plane which is parallel to a sputter face from a sputter front face is 3 mm or less, and a cross section structure of the target is a columnar structure that has grown in a direction of the sputter front face.
2) The Cu-Ga alloy sputtering target according to 1) above, wherein content of respective impurities of P, S, Fe, Ni, and Ag is 10 wtppm or less.
3) The Cu-Ga alloy sputtering target according to 1) or 2) above, wherein content of gas components C, O, N, and H is, in total, 300 wtppm or less.
4) The Cu-Ga alloy sputtering target according to any one of 1) to 3) above, wherein a structure of the target is a γ phase, single phase structure.
5) The Cu-Ga alloy sputtering target according to any one of 1) to 4) above, wherein the target has a columnar structure that has grown from both wide faces (one face is a sputter face) of the target toward a center plane which is parallel to a sputter front face.
6) The Cu-Ga alloy sputtering target according to any one of 1) to 5) above, wherein the target is produced via continuous casting.
7) A method of producing a Cu-Ga alloy sputtering target containing 29 to 42.6 at% of Ga and remainder being Cu and unavoidable impurities, including the steps of melting a target raw material in a crucible, pouring resulting molten metal in a mold comprising a water-cooled probe to continuously produce a casting formed from a Cu-Ga alloy, and additionally machining the obtained casting to produce the Cu-Ga alloy target, wherein a solidification rate of the casting reaching 400°C from a melting point is controlled to 380 to 1000°C/min, and a structure of the casting is a columnar structure in a direction from an inner wall of the casting.
8) The method of producing a Cu-Ga alloy sputtering target according to 7) above, wherein an average crystal grain size of a sputter front face is 3 mm or less, and a cross section structure of the target is a columnar structure that has grown in a direction from the sputter front face toward a center plane which is parallel to a sputter face.
9) The method of producing a Cu-Ga alloy sputtering target according to 7) above, wherein an abstraction rate from the mold is 50 mm/min to 150 mm/min.
10) The method of producing a Cu-Ga alloy sputtering target according to 7) or 8) above, wherein casting is performed using a continuous casting system.
11) The method of producing a Cu-Ga alloy sputtering target according to any one of 7) to 10) above, wherein the casting is intermittently abstracted from the mold.
12) The method of producing a Cu-Ga alloy sputtering target according to any one of 7) to 11) above, wherein content of respective impurities of P, S, Fe, Ni, and Ag is each less than 10 wtppm.
13) The method of producing a Cu-Ga alloy sputtering target according to any one of 7) to 12) above, wherein content of gas components C, O, N, and H is, in total, 300 wtppm or less.
14) The method of producing a Cu-Ga alloy sputtering target according to any one of 7) to 13) above, wherein a structure of the target is a γ phase, single phase structure.

### [Effect of the Invention]

According to the present invention, it is possible to obtain a homogeneous Cu-Ga-based alloy film with low generation of particles by sputtering a Cu-Ga alloy target having a cast structure in which the crystal grains are small and unified. The present invention additionally yields the effect of being able to considerably reduce the production cost of the Cu-Ga alloy target. Since the light-absorbing layer and CIGS-based solar cells can be produced from the foregoing sputtered film, the present invention yields superior effects of being able to inhibit the deterioration in the conversion efficiency of the CIGS solar cells, as well as produce low-cost CIGS-based solar cells.

### BRIEF DESCRIPTION OF THE DRAWINGS

Fig. 1 is a schematic explanatory diagram of a cross section of a representative continuous casting system.
Fig. 2 is an enlarged explanatory diagram of the relevant portion of the continuous casting system.
Fig. 3 is a diagram showing the relation of the abstraction rate and cooling rate of a cast piece.
Fig. 4 is a diagram showing a micrograph of the surface of the target produced based on the present invention upon changing the abstraction rate.
Fig. 5 is a diagram showing a micrograph of the structure of the cross section, which is parallel to the abstracting direction, of the target produced based on the present invention upon changing the abstraction rate.
Fig. 6 is a diagram showing a micrograph of the surface upon etching the polished target surface of Example 6, with nitric acid.
Fig. 7 is a diagram showing a micrograph of the surface upon additionally etching, with nitric acid, the cross section which is parallel to the abstracting direction of the cast piece of Example 6, namely, the polished surface of the target after being subject to machining (surface polishing).
Fig. 8 is a diagram showing a micrograph of the surface upon etching the polished target surface of Example 7, with nitric acid.
Fig. 9 is a diagram showing a micrograph of the surface upon additionally etching, with nitric acid, the cross section which is parallel to the abstracting direction of the cast piece of Example 7, namely, the polished surface of the target after being subject to machining, namely, surface polishing.
Fig. 10 is a diagram showing a micrograph of the surface upon etching the polished target surface of Example 8, with nitric acid.
Fig. 11 is a diagram showing a micrograph of the surface upon additionally etching, with nitric acid, the cross section which is parallel to the abstracting direction of the cast piece of Example 8, namely, the polished surface of the target after being subject to machining, namely, surface polishing.
Fig. 12 is a diagram showing a micrograph of the surface upon etching the polished target surface of Example 9, with nitric acid.
Fig. 13 is a diagram showing a micrograph of the surface upon additionally etching, with nitric acid, the cross section which is parallel to the abstracting direction of the cast piece of Example 9, namely, the polished surface of the target after being subject to machining, namely, surface polishing.

### DETAILED DESCRIPTION OF THE INVENTION

The Cu-Ga alloy sputtering target of the present invention is a melted and cast Cu-Ga alloy sputtering target containing 29 to 42.6 at% of Ga and remainder being Cu and unavoidable impurities.

Generally, a sintered article ideally has a relative density of 95% or higher. This is because, if the relative density is low, generation of particles onto the film and surface unevenness advances rapidly due to the splashes or abnormal discharge that occur around the holes during the emergence of inner holes during sputtering, and abnormal discharge and the like tend to occur with the surface protrusions (nodules) as the starting point.

A casting is able to achieve a relative density of substantially 100%, and is consequently effective for inhibiting the generation of particles during sputtering. This is a major advantage of a casting.

The Ga content is required from demands of forming a Cu-Ga alloy sputtered film which is required upon producing CIGS-based solar cells, and a γ phase, single phase cast structure can be obtained within a Ga content range of 29 to 42.6 at%. A heterophase will occur under conditions outside the foregoing range, and the cast structure cannot be formed into a uniform structure. Thus, the additive amount of Ga is set to be within the foregoing range.

With the sputtering target of the present invention, the average crystal grain size of the sputter front face, namely, the face of the target viewed from the sputtering direction, is 3 mm or less. A sputter face of a structure having fine crystal grain size is effective in forming a uniform film.

While this average crystal grain size can be achieved by controlling the abstraction rate, the average crystal grain size can be made 2 mm or less, and even 1 mm or less.

Moreover, the target of the present invention has a columnar structure that has grown in a direction from the sputter front face toward a center plane which is parallel to a sputter face. This is a major feature of the present invention.

When a Cu-Ga alloy casting is solidified in the mold, crystals grow in a columnar shape from the wall surface of the mold toward the inner direction thereof, but most of such crystals grow in a columnar shape from the wide mold wall surface toward the center direction thereof. Furthermore, most of such crystals grow in a columnar shape in a vertical direction. Consequently, the cross section structure of the target becomes a columnar structure that has grown in a direction from the sputter front face toward a center plane which is parallel to a sputter face. The average diameter of these columnar crystals is 3 mm or less.

Accordingly, since this surface is exposed during sputtering, the average crystal grain size of the sputter face will be 3 mm or less. If the average diameter of the columnar crystals exceeds 3 mm, the width and length of the columnar crystals will approach 1:1, and it can no longer be referred to as columnar crystals.

Consequently, coarse particles will arise in the cast target, and the shape thereof will be columnar crystals for some and spherical particles for others, become non-uniform, which is undesirable since a plurality of such coarse particles will exist sparsely in the thickness direction. From this perspective also, the average crystal grain size of the sputter front face needs to be 3 mm or less.

While P, S, Fe, Ni, and Ag may be listed as impurities in the Cu-Ga alloy sputtering target; the content of the respective impurities described above is desirably each less than 10 wtppm. The impurity content can be adjusted at the stage of the raw material. This is a preferred requirement for improving the characteristics of the CIGS-based solar cells.

Similarly, the content of gas components C, O, N, and H is preferably, in total, 300 wtppm or less. This can be achieved by adopting measures for preventing the mixture of air at the stage of degassing and casting of the Cu-Ga alloy molten metal; for instance, selection of sealing material for the mold and refractory material, and introduction of argon gas or nitrogen gas at such sealed portion. This is also a preferred requirement for improving the characteristics of the CIGS-based solar cells.

The Cu-Ga alloy sputtering target of the present invention can be limited such that the target structure is required to have a γ phase, single phase structure.

Moreover, the target may also have a columnar structure that has grown from both wide faces (one face is a sputter face) of the target toward a center plane which is parallel to a sputter front face. In the foregoing case, most of the target may be formed as a columnar structure that has grown in the vertical direction. In addition, the Cu-Ga alloy sputtering target may be a target having a cast structure that is produced via continuous casting.

The present invention additionally provides a method of producing a Cu-Ga alloy sputtering target containing 29 to 42.6 at% of Ga and remainder being Cu and unavoidable impurities, including the steps of melting a target raw material in a crucible, pouring resulting molten metal in a mold comprising a water-cooled probe to continuously produce a casting formed from a Cu-Ga alloy, and additionally machining the obtained casting to produce the Cu-Ga alloy target. Note that the mold may be selected as needed depending on the intended target shape such as rectangular, columnar, or cylindrical. In the foregoing case, the solidification rate of the casting reaching 400°C from a melting point is controlled to 380 to 1000°C/min, and the structure of the casting is a columnar structure that has grown in a direction toward the inner wall of the mold.

It is thereby possible to achieve a Cu-Ga alloy sputtering target in which the average crystal grain size of the sputter front face is 3 mm or less, and the cross section structure of the target is a columnar structure that has grown in a direction from the sputter front face toward a center plane which is parallel to a sputter face. The average crystal grain size of the Cu-Ga alloy sputtering target can be adjusted by setting the abstraction rate from the mold to 50 mm/min to 150 mm/min.

The foregoing casting can be produced even easier by using a continuous casting system to perform the casting process, and, in addition, intermittently abstracting the casting from the mold. In this kind of casting method, the content of the respective impurities of P, S, Fe, Ni, and Ag can each be 10 wtppm or less, and even 5 wtppm or less each.

Moreover, the content of gas components C, O, N, and H can be, in total, 300 wtppm or less, and additionally the target structure can be a γ phase, single phase structure.

Upon producing the Cu-Ga alloy sputtering target, it is possible to produce a casting in which the cross section of the casting that was abstracted from the mold is 50 mm to 320 mm, and the thickness thereof is 5 mm to 30 mm, and perform machining and surface polishing thereto to obtain a target, and, while these manufacturing conditions are arbitrarily, it could be said that they are favorable conditions.

Upon producing the light-absorbing layer and CIGS-based solar cells from a Cu-Ga-based alloy film, deviation in the composition will considerably change the characteristics of the light-absorbing layer and the CIGS-based solar cells. However, when deposition is performed using the Cu-Ga alloy sputtering target of the present invention, no such deviation of composition can be observed. This is a major advantage of a casting in comparison to a sintered article.

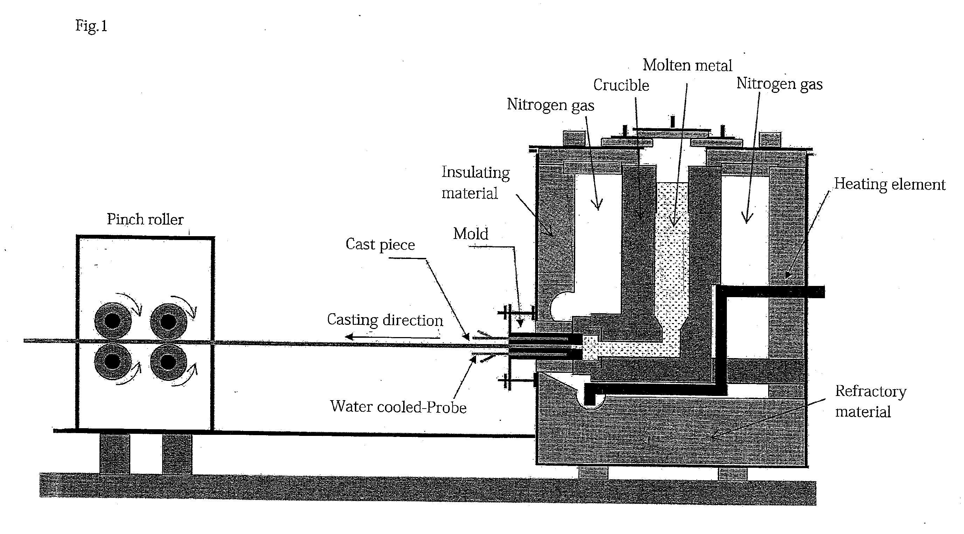

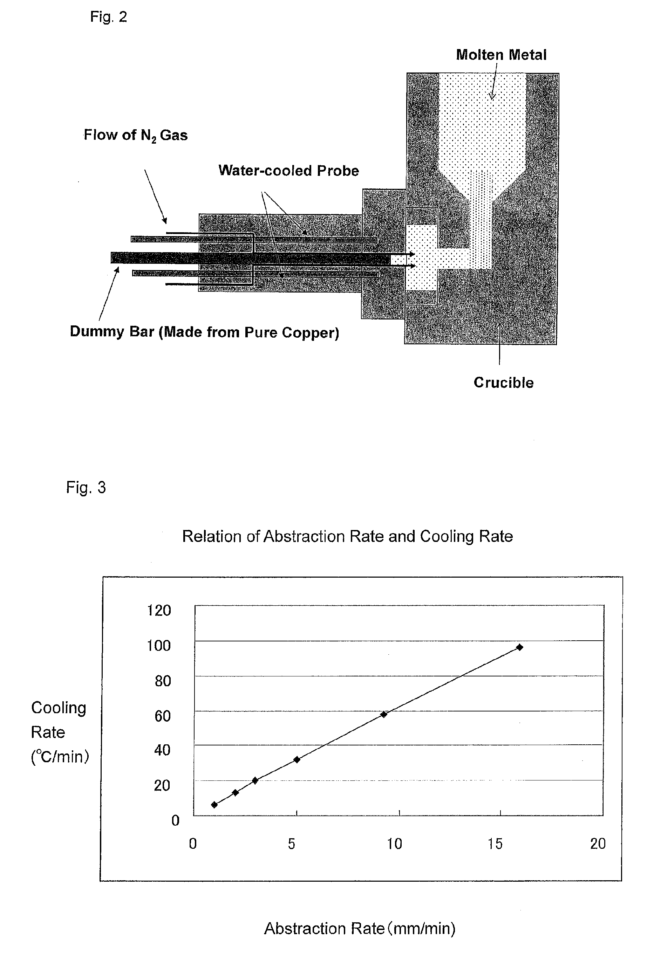

The cross section of a representative continuous casting system used in the present invention is shown in Fig. 1. Moreover, an enlarged view (cross section) of the relevant part thereof is shown in Fig. 2. Note that, while Fig. 1 and Fig. 2 show a lateral continuous casting system, a vertical continuous casting system may also be used. As shown in Fig. 1 and Fig. 2, molten metal of a component-adjusted Cu-Ga alloy is introduced into the crucible. The crucible is normally made of graphite, but a crucible made of ceramic or the like may also be used.

A refractory material surrounds the periphery of the crucible, and this refractory material contains a mold (partial), a heating apparatus for heating the crucible, and a nitrogen gas introduction part for preventing the inclusion of air from the sealed part of the mold and the refractory material. As a result of introducing nitrogen gas, the nitrogen gas is also supplied to the molten metal in the mold, and bubbling of the molten metal is thereby performed. As a result of bubbling the molten metal, gas components in the molten metal are eliminated, and the reduction of gas components can be performed effectively. While a resistance heating apparatus (heating element) is used as the heating apparatus in Fig. 1, an induction heating apparatus may also be used.

A water-cooled probe is disposed inside the mold on the other end of the mold, whereby this structure enables the cooling of the mold. As shown in Fig. 2, a dummy bar is inserted into the mold before starting the casting process. As the dummy bar, a pure copper dummy bar is preferably used. A structure where nitrogen gas can be introduced into the gap between the dummy bar and the mold as shown in Fig. 2 is preferably adopted. The molten metal of Cu-Ga alloy comes into contact with the dummy bar, becomes welded and solidified, and at the same time the dummy bar is abstracted from the mold and, together, the solidified Cu-Ga alloy is also abstracted from the mold.

When regular abstraction is started as shown in Fig. 1, the pinch roller disposed at the front is used to abstract the cast piece (Cu-Ga alloy casting).

Upon performing intermittent abstraction, the drive of this pinch roller is controlled. This intermittent abstraction is effective for reducing impurities. This is considered to be a result of the impurities contained in the Cu-Ga alloy being discharged to the molten metal side during the solidification of the molten metal. It is considered that the impurities were reduced based on the same principle as the zone melting method, which is one type of method for achieving higher purity.

### Examples

The Examples of the present invention are now explained. Note that the following Examples merely illustrate representative examples, and the present invention should not be limited to these Examples. In other words, the present invention covers all modes or variations other than the invention and Examples that can be understood from the overall specification within the scope of the technical concept of the present invention.

### (Example 1)

Foremost, as shown in Fig. 1, using the continuous casting system, 20 kg of a copper (Cu: purity 4N) raw material was placed in a carbon crucible, and the inside of the crucible was made to be a nitrogen gas atmosphere and heated to 1250°C. This high temperature heating was performed to weld a dummy bar and Cu-Ga alloy molten metal.

Next, Ga (purity: 4N) as an additive element was adjusted so that the Ga concentration becomes a composition ratio of 29 at%, and introduced into the heating crucible. A resistance heating apparatus (graphite element) was used for heating the crucible. The shape of the melting crucible was 140 mmϕ × 400 mmϕ, the mold was made from graphite, the shape of the cast ingot was a plate shape of 65 mmw x 12 mmt, and this was subject to continuous casting.

After melting the raw material, the molten metal temperature was lowered to 950°C, and, at the time that the molten metal temperature and the mold temperature became stabilized, abstraction was started. As shown in Fig. 1, since a dummy bar is inserted at the front end of the mold, the solidified cast piece can be abstracted by pulling out the dummy bar.

The abstraction pattern was as follows; namely, driving for 0.5 seconds and stopping for 2.5 seconds were repeated, and the frequency was changed. The abstraction rate was 30 mm/min. The relation of the abstraction rate and the cooling rate of the cast piece is shown in Fig. 3. As shown in Fig. 3, the abstraction rate (mm/min) and the cooling rate (°C/min) are of a proportional relation, and, when the abstraction rate (mm/min) is increased, the cooling rate will also increase.

A water-cooled probe was inserted into the mold as shown in Fig. 2, and the temperature was measured from the molten metal side at 5 points in intervals of 20 mm; namely, 30 mm, 50 mm, 70 mm, 90 mm, and 110 mm using a thermocouple up to a position that is roughly half of the mold. In the measurement results, there was a thermal gradient of approximately 130°C for every 20 mm. The results are shown in Table 1. Table 1 also shows the additive amount of Ga, and the amount (wtppm) of gas components C, O, N, and H.

**[Table 1]**

| | | Ga | C | O | N | H |
|---|---|---|---|---|---|---|
| | Unit | at% | wtppm | wtppm | wtppm | wtppm |
| Comparative Example 1 | 10 mm/min | 29.0 | 30 | 30 | <10 | <10 |
| Comparative Example 2 | 20 mm/min | 29.0 | 20 | 50 | <10 | <10 |
| Example 1 | 30 mm/min | 29.2 | 20 | 40 | <10 | <10 |
| Example 2 | 50 mm/min | 29.3 | 50 | 40 | <10 | <10 |
| Example 3 | 92 mm/min | 29.2 | 30 | 60 | <10 | <10 |
| Example 4 | 159 mm/min | 29.3 | 30 | 30 | <10 | <10 |

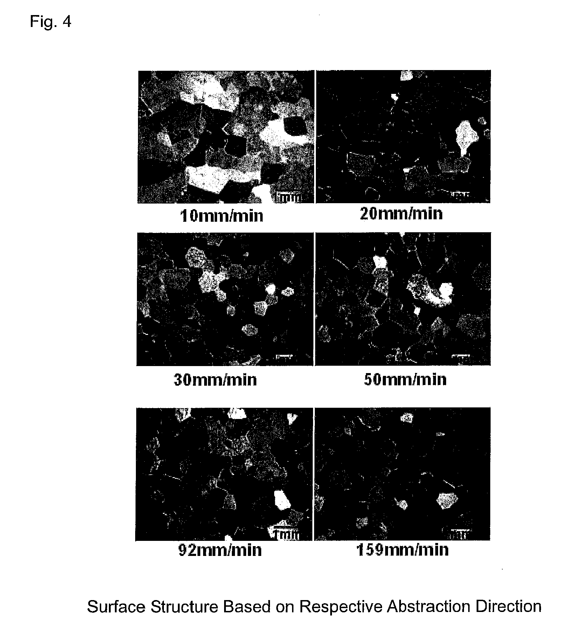

The relation of the abstraction rate and the cooling rate of the cast piece is shown in Fig. 3. Fig. 4 is a diagram showing a surface micrograph upon changing the abstraction rate. When the abstraction rate is relatively fast at 30 mm/min as in Example 1, the surface of the cast piece was subject to machining; namely, surface polishing to obtain a target, and "machining "hereinafter refers to "surface polishing". The micrograph of the surface after etching the polished surface with nitric acid is shown in Fig. 4. The average crystal grain size of the target surface shown in the left center of Fig. 4 was 3 mm or less, and mostly 1 mm or less.

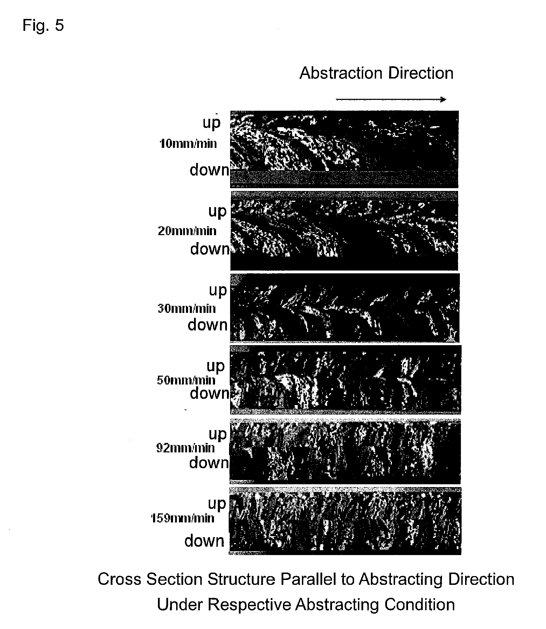

Meanwhile, a micrograph of the structure of the surface upon additionally etching, with nitric acid, the cross section which is parallel to the abstracting direction of the cast piece; that is, the polished surface of the target after being subject to machining is shown in Fig. 5.

As shown in the third micrograph from the top in Fig. 5, it is observed that the columnar crystals along the abstracting direction of the cast piece are curved. Nevertheless, even if the columnar crystals are curved near the center plane, since the degree thereof is small, the target surface will have a structure in which the average crystal grain size is constantly 3 mm or less, and this will not cause a particular problem during sputtering.

As a result of sputtering this kind of Cu-Ga alloy target having a cast structure and in which the crystal grains are small and unified, a superior effect is yielded in that a homogeneous Cu-Ga-based alloy film with low generation of particles can be obtained.

### (Example 2)

Example 2 is a case where the abstraction rate was even faster than Example 1; that is, 50 mm/min, and the other manufacturing conditions were the same as Example 1. While the surface of the cast piece was subject to machining to obtain a target, the micrograph of the surface after etching the polished target surface with nitric acid is shown in Fig. 4. The average crystal grain size of the target surface of Example 2 shown in the right center of Fig. 4 was 2 mm or less, and mostly 1 mm or less.

Meanwhile, a micrograph of the structure of the surface upon additionally etching, with nitric acid, the cross section which is parallel to the abstracting direction of the cast piece; that is, the polished face of the target after being subject to machining is shown in Fig. 5. As shown in the fourth micrograph from the top in Fig. 5, while the columnar crystals are slightly curved from the surface of the cast piece, which is to become the surface of the target, toward the center plane which is parallel to the sputter face, the substantial alignment of the columnar crystals in the vertical direction can be observed. With the target surface, it was possible to obtain a structure in which the average crystal grain size is constantly 3 mm or less.

As a result of sputtering this kind of Cu-Ga alloy target having a cast structure and in which the crystal grains are small and unified, a superior effect is yielded in that a homogeneous Cu-Ga-based alloy film with low generation of particles can be obtained.

### (Example 3)

Example 3 is a case where the abstraction rate was even faster than Example 2; that is, 92 mm/min, and the other manufacturing conditions were the same as Example 1 and Example 2. While the surface of the cast piece was subject to machining to obtain a target, the micrograph of the surface after etching the polished target surface with nitric acid is shown in Fig. 4. The average crystal grain size of the target surface of Example 3 shown in the right center of Fig. 4 was 1 mm or less.

Meanwhile, a micrograph of the structure of the surface upon additionally etching, with nitric acid, the cross section which is parallel to the abstracting direction of the cast piece; that is, the polished face of the target after being subject to machining is shown in Fig. 5.

As shown in the fifth micrograph from the top in Fig. 5, the substantial alignment of the columnar crystals in the vertical direction from the surface of the cast piece, which is to become the surface of the target, toward the center plane which is parallel to the sputter face can be observed. With the target surface, it was possible to obtain a structure in which the average crystal grain size is constantly 1 mm or less.

As a result of sputtering this kind of Cu-Ga alloy target having a cast structure and in which the crystal grains are small and unified, a superior effect is yielded in that a homogeneous Cu-Ga-based alloy film with low generation of particles can be obtained.

### (Example 4)

Example 4 is a case where the abstraction rate was even faster than Example 3; that is, 159 mm/min, and the other manufacturing conditions were the same as Example 1, Example 2 and Example 3. While the surface of the cast piece was subject to machining to obtain a target, the micrograph of the surface after etching the polished target surface with nitric acid is shown in Fig. 4. The average crystal grain size of the target surface of Example 4 shown in the right center of Fig. 4 was 1 mm or less.

Meanwhile, a micrograph of the structure of the surface upon additionally etching, with nitric acid, the cross section which is parallel to the abstracting direction of the cast piece; that is, the polished face of the target after being subject to machining, is shown in Fig. 5.

As shown in the sixth micrograph from the top in Fig. 5, the substantial alignment of the columnar crystals in the vertical direction from the surface of the cast piece toward the center plane which is parallel to the sputter face can be observed. With the target surface, it was possible to obtain a structure in which the average crystal grain size is constantly 1 mm or less.

As a result of sputtering this kind of Cu-Ga alloy target having a cast structure and in which the crystal grains are small and unified, a superior effect is yielded in that a homogeneous Cu-Ga-based alloy film with low generation of particles can be obtained.

### (Comparative Example 1)

Comparative Example 1 is a case where the abstraction rate was slower than Example 1; that is, 10 mm/min, and the other manufacturing conditions were the same as Example 1. While the surface of the cast piece was subject to machining to obtain a target, the micrograph of the surface after etching the polished target surface with nitric acid is shown in Fig. 4. The average crystal grain size of the target surface of Comparative Example 1 shown in the upper left of Fig. 4 exceeded 3 mm or less, and the grain size was not uniform.

Meanwhile, a micrograph of the structure of the surface upon additionally etching, with nitric acid, the cross section which is parallel to the abstracting direction of the cast piece; that is, the polished face of the target after being subject to machining is shown in Fig. 5. As shown in the first micrograph from the top in Fig. 5, it can be seen that the columnar crystals are considerably curved, or flown from the surface of the cast piece toward the center plane which is parallel to the sputter face.

As shown in Fig. 3, with continuous casting, the cooling rate becomes slow when the abstraction rate is slow; in particular, the solidification becomes slow inside the cast piece in comparison to the surface, i.e., face to come into contact with the mold, and therefore it is considered that the slanted shape or curved shape is a result of the ongoing delay in precipitation relative to the initially precipitated columnar crystals. Thus, it is considered that the shape of crystals appearing on the surface of the cast piece is reflected in the slanted shape or curved shape, thereby causing the lateral cross section of the crystals to be a non-grain shape which is irregular and coarse.

Consequently, with the surface of the target obtained from the foregoing cast piece, upon approaching the center plane, the average crystal grain size exceeded 3 mm, and a structure with an uneven shape was obtained. As a result of sputtering this kind of Cu-Ga alloy target having a cast structure in which the crystal grains are not uniform is sputtered, there are problems in that the generation of particles will increase, and a heterogeneous Cu-Ga-based alloy film is obtained.

### (Comparative Example 2)

Comparative Example 2 is a case where the abstraction rate was slightly faster than Comparative Example 1; that is, 20 mm/min, and the other manufacturing conditions were the same as Comparative Example 1. While the surface of the cast piece was subject to machining to obtain a target, the micrograph of the surface after etching the polished target surface with nitric acid is shown in Fig. 4. The average crystal grain size of the target surface of Comparative Example 2 shown in the upper right of Fig. 4 exceeded 3 mm or less, and the grain size was not uniform. While the flow has slightly improved from Comparative Example 1, it was not possible to achieve the object of the present invention.

Meanwhile, a micrograph of the structure of the surface upon additionally etching, with nitric acid, the cross section which is parallel to the abstracting direction of the cast piece; that is, the polished face of the target after being subject to machining, is shown in Fig. 5. As shown in the second micrograph from the top in Fig. 5, it can be seen that the columnar crystals are considerably curved (flowing) from the surface of the cast piece toward the center plane which is parallel to the sputter face.

Consequently, with the surface of the target, upon approaching the center plane, the average crystal grain size exceeded 3 mm, and a structure with an uneven shape was obtained. As a result of sputtering this kind of Cu-Ga alloy target having a cast structure in which the crystal grains are not uniform is sputtered, there are problems in that the generation of particles will increase, and a heterogeneous Cu-Ga-based alloy film is obtained.

As shown in the foregoing Examples and Comparative Examples, with a melted and cast Cu-Ga alloy sputtering target containing 29 to 42.6 at% of Ga and remainder being Cu and unavoidable impurities, it can be seen that the average crystal grain size of the sputter front face being 3 mm or less, and the cross section structure of the target being a columnar structure that has grown in a direction from the sputter front face toward the center plane which is parallel to the sputter face play important roles in forming a homogeneous Cu-Ga-based alloy film with low generation of particles.

### (Example 5)

Next, Example 5 shows a case where, as the main impurities contained in the Cu raw material, the high concentration impurities shown in Table 2 are contained; that is, a case where the following impurities are contained; namely, P: 2.8 wtppm, S: 3.9 wtppm, Fe: 1.3 wtppm, Ni: 0.63 wtppm, and Ag: 8.6 wtppm. Note that the gas components were the same as Example 4; that is, C: 30 wtppm, O: 30 wtppm, N: <10 wtppm, and H: <10 wtppm.

The continuous casting method of Example 5 was the same method as Example 4. Consequently, it was possible to obtain a Cu-Ga alloy target having a cast structure and in which the crystal grains are small and unified, which was equivalent to Example 4. Thus, impurities in the raw material did not affect the cast structure.

In Example 5, upon additionally measuring the impurity content of the target produced via continuous casting, the result were P: 0.33 wtppm, S: 2.6 wtppm, Fe: 0.5 wtppm, Ni: 0.21 wtppm, and Ag: 1.3 wtppm, and a signification reduction effect was obtained. Accordingly, a Cu-Ga alloy cast target produced via continuous casting is unique in that it can yield an impurity reduction effect. This is considered to be a result of the impurities contained in the Cu-Ga alloy being discharged to the molten metal side during the solidification of the molten metal as described above. It is considered that the impurities were reduced based on the same principle as the zone melting method, which is one type of method for achieving higher purity.

**[Table 2]**

| | Cu raw material | Comparative Example 3 | Example 5 |
|---|---|---|---|
| P | 2.8 | 2.2 | 0.33 |
| S | 3.9 | 3.2 | 2.6 |
| Fe | 1.3 | 0.64 | 0.5 |
| Ni | 0.63 | 0.55 | 0.21 |
| Ag | 8.6 | 10 | 1.3 |

| | | | |
|---|---|---|---|
| Impurity content (Unit: wtppm) | | | |

### (Comparative Example 3)

Next, Comparative Example 3 shows a case where, as the main impurities contained in the Cu raw material, the high concentration impurities shown in Table 2 are contained; that is, a case where the following impurities are contained; namely, P: 2.8 wtppm, S: 3.9 wtppm, Fe: 1.3 wtppm, Ni: 0.63 wtppm, and Ag: 8.6 wtppm.

The casting method of Comparative Example 3 was the placed pouring method, or the standard cast method, and a graphite mold having the same dimensions as Example 4 was cast.

Consequently, as a result of measuring the impurity content of the target produced in Comparative Example 3, the results were P: 2.2 wtppm, S: 3.2 wtppm, Fe: 0.64 wtppm, Ni: 0.55 wtppm, and Ag: 10 wtppm, and no impurity reduction effect could be observed.

Based on the comparison of Example 5 and Comparative Example 3, it was possible to confirm that the Cu-Ga alloy cast target produced via continuous casting not only yields the effect of improving the cast structure, but also yields a significant effect of being able to yield an impurity reduction effect.

### (Example 6)

Next, Example 6 shows a case where a 4N Cu raw material and a 4N Ga raw material were prepared in order to produce a Cu-Ga alloy containing 35 at% of Ga and remainder being Cu. These raw materials contained the following impurities; namely, P: 2.8 wtppm, S: 3.9 wtppm, Fe: 1.3 wtppm, Ni: 0.63 wtppm, and Ag: 8.6 wtppm, as well as the following gas components; namely, C: 30 wtppm, O: 30 wtppm, N: <10 wtppm, and H: <10 wtppm.

Using the same continuous casting system as Example 1, the crucible was heated to 1250°C, the Cu and Ga raw materials were placed therein, the molten metal temperature was thereafter lowered to 915°C, and, after the temperature became stabilized, the abstraction of the cast piece was started. The abstraction rate was 30 mm/min.

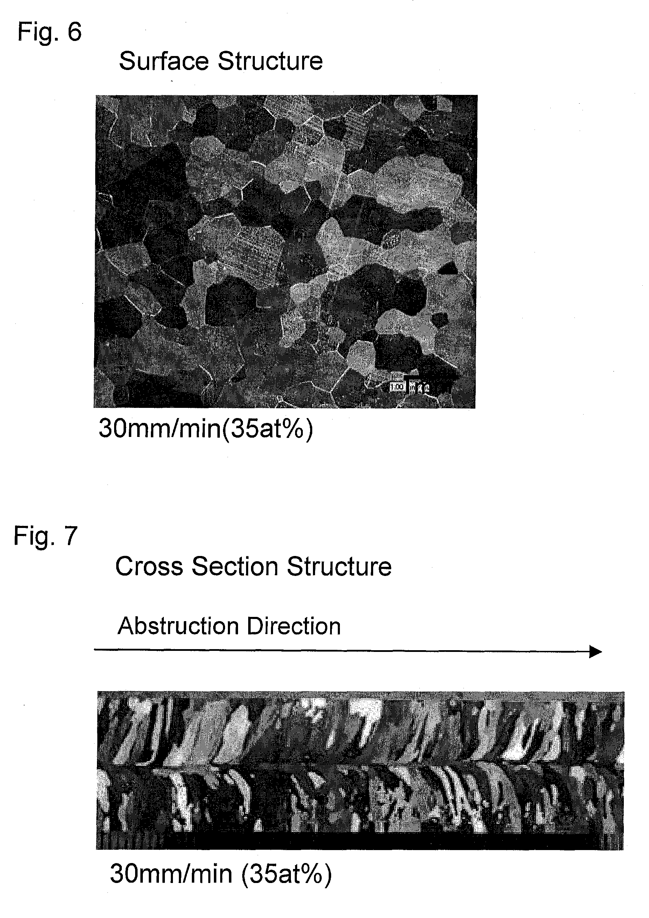

The other manufacturing conditions were the same as Example 1, Example 2 and Example 3. While the surface of the cast piece was subject to machining to obtain a target, the micrograph of the surface after etching the polished target surface with nitric acid is shown in Fig. 6. The average crystal grain size of the target surface of Example 6 was 1 mm or less.

Meanwhile, a micrograph of the structure of the surface upon additionally etching, with nitric acid, the cross section which is parallel to the abstracting direction of the cast piece; that is, the polished face of the target after being subject to machining is shown in Fig. 7.

As shown in this micrograph, the substantial alignment of the columnar crystals in the vertical direction from the surface of the cast piece toward the center plane which is parallel to the sputter face can be observed. With the target surface, it was possible to obtain a structure in which the average crystal grain size is constantly 1 mm or less.

Consequently, as a result of measuring the impurity content of the target produced in Example 6, the results were P: 0.24 wtppm, S: 2.3 wtppm, Fe: 0.45 wtppm, Ni: 0.17 wtppm, and Ag: 1.5 wtppm, and a significant impurity reduction effect was obtained. Moreover, the gas impurities were C: 20 wtppm, O: 30 wtppm, N: <10 wtppm, and H: <10 wtppm. The results are shown in Table 3.

Accordingly, a Cu-Ga alloy cast target produced via continuous casting is unique in that it can yield an impurity reduction effect. This is considered to be a result of the impurities contained in the Cu-Ga alloy being discharged to the molten metal side during the solidification of the molten metal as described above.

**[Table 3]**

| | Abstraction rate | Ga composition | C | O | N | H | P | S | Fe | Ni | Ag |
|---|---|---|---|---|---|---|---|---|---|---|---|
| Example 6 | 30 mm/min | 35.0 at% | 20 | 30 | <10 | <10 | 0.24 | 2.3 | 0.45 | 0.17 | 1.5 |
| Example 7 | 150 mm/min | 35.0 at% | 20 | 30 | <10 | <10 | 0.38 | 2.5 | 0.53 | 0.19 | 1.4 |
| Example 8 | 30 mm/min | 40.0 at% | 20 | 40 | <10 | <10 | 0.33 | 2.4 | 0.38 | 0.21 | 1.8 |
| Example 9 | 150 mm/min | 40.0 at% | 30 | 30 | <10 | <10 | 0.41 | 2.8 | 0.48 | 0.24 | 2.1 |

| | | | | | | | | | | | |
|---|---|---|---|---|---|---|---|---|---|---|---|
| *Impurities (Unit: wtppm) | | | | | | | | | | | |

### (Example 7)

Next, Example 7 shows a case where a 4N Cu raw material and a 4N Ga raw material were prepared in order to produce a Cu-Ga alloy containing 35 at% of Ga and remainder being Cu. These raw materials contained the following impurities; namely, P: 2.8 wtppm, S: 3.9 wtppm, Fe: 1.3 wtppm, Ni: 0.63 wtppm, and Ag: 8.6 wtppm, as well as the following gas components; namely, C: 30 wtppm, O: 30 wtppm, N: <10 wtppm, and H: <10 wtppm.

Using the same continuous casting system as Example 1, the crucible was heated to 1250°C, the Cu and Ga raw materials were placed therein, the molten metal temperature was thereafter lowered to 915°C, and, after the temperature became stabilized, the abstraction of the cast piece was started. The abstraction rate was 150 mm/min.

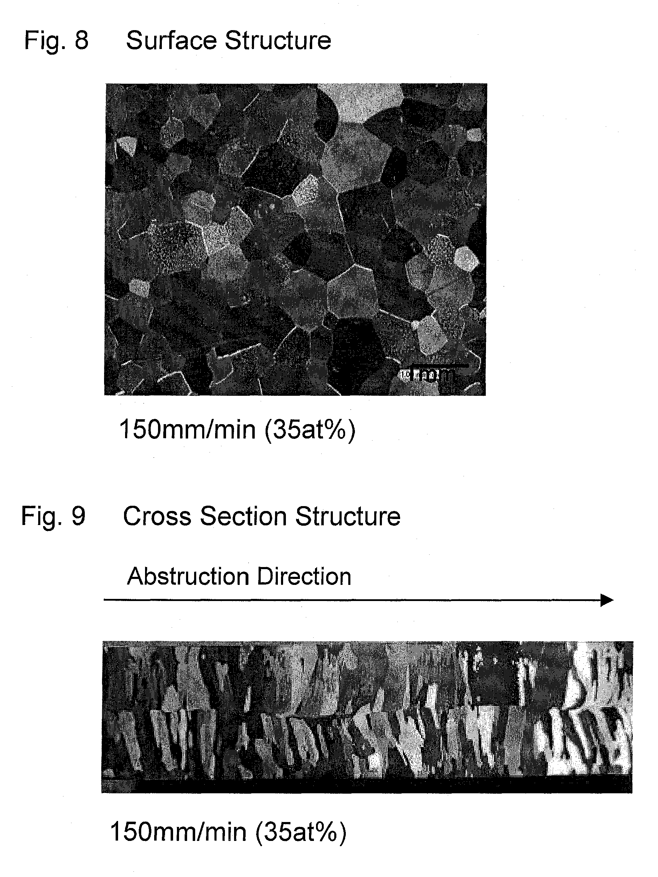

The other manufacturing conditions were the same as Example 1, Example 2 and Example 3. While the surface of the cast piece was subject to machining to obtain a target, the micrograph of the surface after etching the polished target surface with nitric acid is shown in Fig. 8. The average crystal grain size of the target surface of Example 7 was 1 mm or less.

Meanwhile, a micrograph of the structure of the surface upon additionally etching, with nitric acid, the cross section which is parallel to the abstracting direction of the cast piece; that is, the polished face of the target machining is shown in Fig. 9.

As shown in this micrograph, the substantial alignment of the columnar crystals toward the surface of the cast piece in the vertical direction toward the target surface can be observed. With the target surface, it was possible to obtain a structure in which the average crystal grain size is constantly 1 mm or less.

Consequently, as a result of measuring the impurity content of the target produced in Example 7, the results were P: 0.38 wtppm, S: 2.5 wtppm, Fe: 0.53 wtppm, Ni: 0.19 wtppm, and Ag: 1.4 wtppm, and a significant impurity reduction effect was obtained. Moreover, the gas impurities were C: 20 wtppm, O: 30 wtppm, N: <10 wtppm, and H: <10 wtppm. The results are shown in Table 3.

Accordingly, a Cu-Ga alloy cast target produced via continuous casting is unique in that it can yield an impurity reduction effect. This is considered to be a result of the impurities contained in the Cu-Ga alloy being discharged to the molten metal side during the solidification of the molten metal as described above.

### (Example 8)

Next, Example 8 shows a case where a 4N Cu raw material and a 4N Ga raw material were prepared in order to produce a Cu-Ga alloy containing 40 at% of Ga and remainder being Cu. These raw materials contained the following impurities; namely, P: 2.8 wtppm, S: 3.9 wtppm, Fe: 1.3 wtppm, Ni: 0.63 wtppm, and Ag: 8.6 wtppm, as well as the following gas components; namely, C: 30 wtppm, O: 30 wtppm, N: <10 wtppm, and H: <10 wtppm.

Using the same continuous casting system as Example 1, the crucible was heated to 1250°C, the Cu and Ga raw materials were placed therein, the molten metal temperature was thereafter lowered to 860°C, and, after the temperature became stabilized, the abstraction of the cast piece was started. The abstraction rate was 30 mm/min.

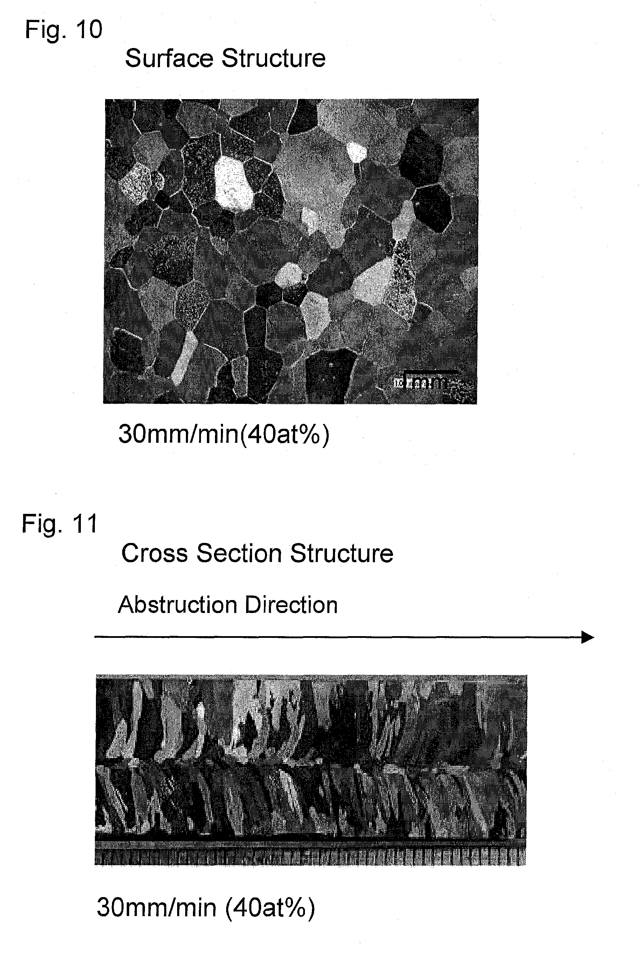

The other manufacturing conditions were the same as Example 1, Example 2 and Example 3. While the surface of the cast piece was subject to machining to obtain a target, the micrograph of the surface after etching the polished target surface with nitric acid is shown in Fig. 10. The average crystal grain size of the target surface of Example 8 was 1 mm or less.

Meanwhile, a micrograph of the structure of the surface upon additionally etching, with nitric acid, the cross section which is parallel to the abstracting direction of the cast piece; that is, the polished face of the target after being subject to machining is shown in Fig. 11.

As shown in this micrograph, the substantial alignment of the columnar crystals in the vertical direction from the surface of the cast piece toward the center plane which is parallel to the sputter face can be observed. With the target surface, it was possible to obtain a structure in which the average crystal grain size is constantly 1 mm or less.

Consequently, as a result of measuring the impurity content of the target produced in Example 8, the results were P: 0.33 wtppm, S: 2.4 wtppm, Fe: 0.38 wtppm, Ni: 0.21 wtppm, and Ag: 1.8 wtppm, and a significant impurity reduction effect was obtained. Moreover, the gas impurities were C: 20 wtppm, O: 40 wtppm, N: <10 wtppm, and H: <10 wtppm. The results are shown in Table 3.

Accordingly, a Cu-Ga alloy cast target produced via continuous casting is unique in that it can yield an impurity reduction effect. This is considered to be a result of the impurities contained in the Cu-Ga alloy being discharged to the molten metal side during the solidification of the molten metal as described above.

### (Example 9)

Next, Example 9 shows a case where a 4N Cu raw material and a 4N Ga raw material were prepared in order to produce a Cu-Ga alloy containing 40 at% of Ga and remainder being Cu. These raw materials contained the following impurities; namely, P: 2.8 wtppm, S: 3.9 wtppm, Fe: 1.3 wtppm, Ni: 0.63 wtppm, and Ag: 8.6 wtppm, as well as the following gas components; namely, C: 30 wtppm, O: 30 wtppm, N: <10 wtppm, and H: <10 wtppm.

Using the same continuous casting system as Example 1, the crucible was heated to 1250°C, the Cu and Ga raw materials were placed therein, the molten metal temperature was thereafter lowered to 860°C, and, after the temperature became stabilized, the abstraction of the cast piece was started. The abstraction rate was 150 mm/min.

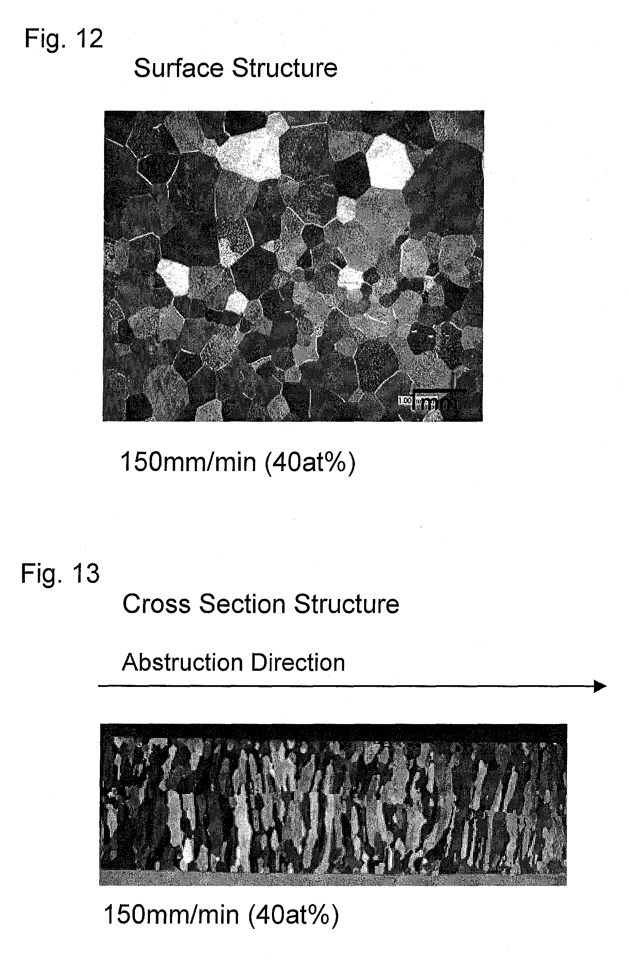

The other manufacturing conditions were the same as Example 1, Example 2 and Example 3. While the surface of the cast piece was subject to machining to obtain a target, the micrograph of the surface after etching the polished target surface with nitric acid is shown in Fig. 12. The average crystal grain size of the target surface of Example 9 was 1 mm or less.

Meanwhile, a micrograph of the structure of the surface upon additionally etching, with nitric acid, the cross section which is parallel to the abstracting direction of the cast piece; that is, the polished face of the target after being subject to machining, is shown in Fig. 13. As shown in this micrograph, the substantial alignment of the columnar crystals in the vertical direction from the surface of the cast piece toward the center plane which is parallel to the sputter face can be observed. With the target surface, it was possible to obtain a structure in which the average crystal grain size is constantly 1 mm or less.

Consequently, as a result of measuring the impurity content of the target produced in Example 9, the results were P: 0.41 wtppm, S: 2.8 wtppm, Fe: 0.48 wtppm, Ni: 0.24 wtppm, and Ag: 2.1 wtppm, and a significant impurity reduction effect was obtained. Moreover, the gas impurities were C: 30 wtppm, O: 30 wtppm, N: <10 wtppm, and H: <10 wtppm. The results are shown in Table 3.

Accordingly, a Cu-Ga alloy cast target produced via continuous casting is unique in that it can yield an impurity reduction effect. This is considered to be a result of the impurities contained in the Cu-Ga alloy being discharged to the molten metal side during the solidification of the molten metal as described above.

### [Industrial Applicability]

According to the present invention, it is possible to obtain a homogeneous Cu-Ga-based alloy film with low generation of particles by sputtering a Cu-Ga alloy target having a cast structure in which the crystal grains are small and unified. The present invention additionally yields the effect of being able to considerably reduce the production cost of the Cu-Ga alloy target. Since the light-absorbing layer and CIGS-based solar cells can be produced from the foregoing sputtered film, the present invention is effective for inhibiting the deterioration in the conversion efficiency of the CIGS solar cells.

## Claims

1. A melted and cast Cu-Ga alloy sputtering target containing 29 to 42.6 at% of Ga and remainder being Cu and unavoidable impurities, wherein an average crystal grain size of a sputter front face is 3 mm or less, and a cross section structure of the target is a columnar structure that has grown in a direction from the sputter front face toward a center plane which is parallel to a sputter face.

2. The Cu-Ga alloy sputtering target according to claim 1, wherein content of respective impurities of P, S, Fe, Ni, and Ag is each less than 10 wtppm.

3. The Cu-Ga alloy sputtering target according to claim 1 or claim 2, wherein content of gas components C, O, N, and H is, in total, 300 wtppm or less.

4. The Cu-Ga alloy sputtering target according to any one of claims 1 to 3, wherein a structure of the target is a γ phase, single phase structure.

5. The Cu-Ga alloy sputtering target according to any one of claims 1 to 4, wherein the target has a columnar structure that has grown from both wide faces (one face is a sputter face) of the target toward a center plane which is parallel to a sputter front face.

6. The Cu-Ga alloy sputtering target according to any one of claims 1 to 5, wherein the target is produced via continuous casting.

7. A method of producing a Cu-Ga alloy sputtering target containing 29 to 42.6 at% of Ga and remainder being Cu and unavoidable impurities, including the steps of melting a target raw material in a crucible, pouring resulting molten metal in a mold comprising a water-cooled probe to continuously produce a casting formed from a Cu-Ga alloy, and additionally machining the obtained casting to produce the Cu-Ga alloy target, wherein a solidification rate of the casting reaching 400°C from a melting point is controlled to 380 to 1000°C/min, and a structure of the casting is a columnar structure that has grown in a direction from an inner wall of the mold toward an inner part of the casting.

8. The method of producing a Cu-Ga alloy sputtering target according to claim 7, wherein an average crystal grain size of a sputter front face is 3 mm or less, and a cross section structure of the target is a columnar structure that has grown in a direction from the sputter front face toward a center plane which is parallel to a sputter face.

9. The method of producing a Cu-Ga alloy sputtering target according to claim 7, wherein an abstraction rate from the mold is 30 mm/min to 150 mm/min.

10. The method of producing a Cu-Ga alloy sputtering target according to claim 7 or claim 8, wherein casting is performed using a continuous casting system.

11. The method of producing a Cu-Ga alloy sputtering target according to any one of claims 7 to 10, wherein the casting is intermittently abstracted from the mold.

12. The method of producing a Cu-Ga alloy sputtering target according to any one of claims 7 to 11, wherein content of respective impurities of P, S, Fe, Ni, and Ag is each 10 wtppm or less.

13. The method of producing a Cu-Ga alloy sputtering target according to any one of claims 7 to 12, wherein content of gas components C, O, N, and H is, in total, 300 wtppm or less.

14. The method of producing a Cu-Ga alloy sputtering target according to any one of claims 7 to 13, wherein a structure of the target is a γ phase, single phase structure.
